# EUROPEAN PATENT APPLICATION

(11) **EP 3 531 160 A1**
(43) Date of publication of application: **28.08.2019**
(21) Application number: 18158080.4
(22) Date of filing: 22.02.2018
(51) Int. Cl.: G01R 33/565, G01R 33/485

(54) **EDDY CURRENT CORRECTION IN MR SPECTROSCOPY**

(71) Applicant: Koninklijke Philips N.V., 5656 AE Eindhoven (NL)
(72) Inventor: VAN DER MEULEN, Peter, 5656 AE Eindhoven (NL)
(74) Representative: de Haan, Poul Erik

(57) **Abstract**

The invention relates to a method of MR imaging or MR spectroscopy of an object. It is an object of the invention to improve the suppression of magnetic field gradient switching-induced sidebands. The method of the invention comprises the steps of:
- subjecting the object (10) to a first measurement sequence comprising at least one RF excitation pulse and a number of switched magnetic field gradients;
- acquiring first MR signals;
- subjecting the object (10) to a second measurement sequence identical to the first measurement sequence, with the difference that at least some of the switched magnetic field gradients of the second measurement sequence have the opposite polarity of the corresponding switched magnetic field gradients of the first measurement sequence,
- acquiring second MR signals;
- repeating the succession of steps a) through d) a number of times, wherein the acquired first and second MR signals are superposed to obtain averaged MR signals; and
- reconstructing an MR image from the averaged MR signals and/or deriving an MR spectrum from the averaged MR signals. Moreover, the invention relates to a MR device (1) and to a computer program for a MR device (1).

## Description

### FIELD OF THE INVENTION

The invention relates to the field of magnetic resonance (MR) imaging. It concerns a method of MR imaging or MR spectroscopy of an object placed in the examination volume of a MR device. The invention also relates to a MR device and to a computer program to be run on a MR device.

### BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

According to the MR method in general, the body of the patient to be examined is arranged in a strong, uniform magnetic field Bo whose direction at the same time defines an axis (normally the z-axis) of the co-ordinate system to which the measurement is related. The magnetic field B₀ produces different energy levels for the individual nuclear spins in dependence on the magnetic field strength which can be excited (spin resonance) by application of an electromagnetic alternating field (RF field) of defined frequency (so-called Larmor frequency, or MR frequency). From a macroscopic point of view the distribution of the individual nuclear spins produces an overall magnetization which can be deflected out of the state of equilibrium by application of an electromagnetic pulse of appropriate frequency (RF pulse) while the corresponding magnetic field B₁ of this RF pulse extends perpendicular to the z-axis, so that the magnetization performs a precessional motion about the z-axis. The precessional motion describes a surface of a cone whose angle of aperture is referred to as flip angle. The magnitude of the flip angle is dependent on the strength and the duration of the applied electromagnetic pulse. In the case of a so-called 90° pulse, the magnetization is deflected from the z axis to the transverse plane (flip angle 90°).

After termination of the RF pulse, the magnetization relaxes back to the original state of equilibrium, in which the magnetization in the z direction is built up again with a first time constant T₁ (spin lattice or longitudinal relaxation time), and the magnetization in the direction perpendicular to the z direction relaxes with a second and shorter time constant T₂ (spin-spin or transverse relaxation time). The transverse magnetization and its variation can be detected by means of receiving RF coils which are arranged and oriented within an examination volume of the MR device in such a manner that the variation of the magnetization is measured in the direction perpendicular to the z-axis. The decay of the transverse magnetization is accompanied by dephasing taking place after RF excitation caused by local magnetic field inhomogeneities facilitating a transition from an ordered state with the same signal phase to a state in which all phase angles are uniformly distributed. The dephasing can be compensated by means of a refocusing RF pulse (for example a 180° pulse). This produces an echo signal (spin echo) in the receiving coils.

In order to realize spatial resolution in the body, time-varying magnetic field gradients extending along the three main axes are superposed on the uniform magnetic field Bo, leading to a linear spatial dependency of the spin resonance frequency. The signal picked up in the receiving coils then contains components of different frequencies which can be associated with different locations in the body. The signal data obtained via the receiving coils correspond to the spatial frequency domain and are called k-space data. The k-space data usually include multiple lines acquired with different phase encoding. Each line is digitized by collecting a number of samples. A set of k-space data is converted to an MR image by means of Fourier transformation.

Magnetic resonance spectroscopy (MRS) or magnetic resonance spectroscopic imaging (MRSI) are methods using the phenomenon of nuclear magnetic resonance to identify the chemical state of various elements. MRS/MRSI therefore provides information about the chemical composition of the tissues of the examined object and the changes in chemical composition, which may occur with disease processes. The underlying principle of MRS is the chemical shift effect. The structure of the electron cloud around each nucleus is specific to an individual molecule or compound. The resonance frequency of a specific nucleus is proportional to the magnetic field that it experiences and is thus influenced by the small chemical field shift generated by the electron cloud in a specific chemical environment. MRS thus allows a (spatially resolved) chemical analysis by analyzing the MR response signal into its frequency components.

Proton Magnetic Resonance Spectroscopy is mainly employed in studies of the brain where prominent peaks arise from NAA (N-acetylaspartic acid), choline containing compounds, creatine and creatine phosphate, myo-inositol and, if present, lactate.

However, in vivo ¹H MR spectra often suffer from severe artefacts originating from switching of magnetic field gradients. The gradient switching induces eddy currents which - in turn - induce a time-dependent magnetic field, leading to a modulation of the acquired MR signals. In the frequency domain, the according sidebands are located symmetrically around the carrier signal. Since the intensities of the sidebands are proportional to the intensities of the original signals, the artefacts originating from the water signal may be larger than the metabolite signals that are of actual interest. Therefore, these sidebands constitute strong sources of errors in the spectral analysis and spectral quantification and have to be removed to allow reliable and accurate results.

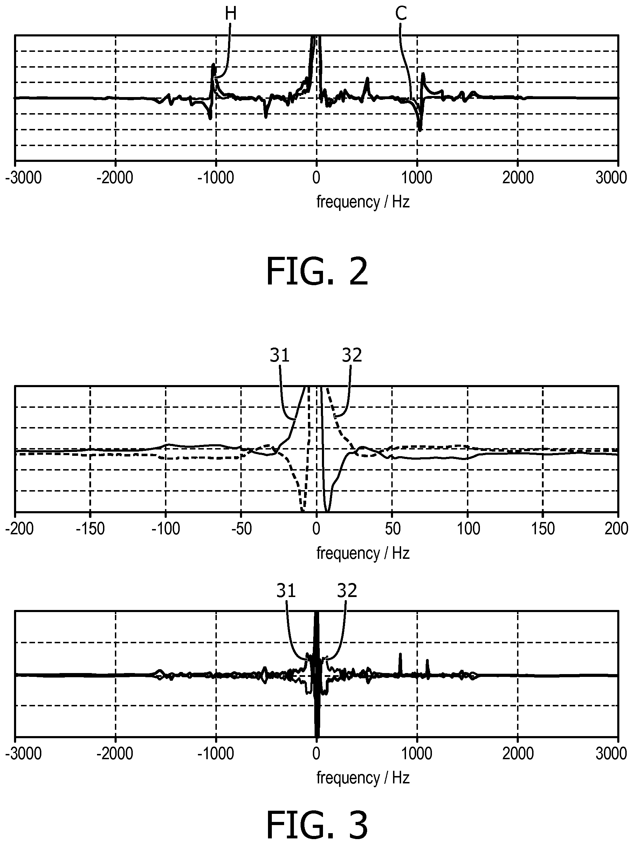

As an example, Fig. 2 shows an MR spectrum of water. The graph shows the eddy current-induced side bands of the water peak for two situations: cold gradient coil (curve C) and hot gradient coil (curve H). As can be seen in Fig.2, especially the peaks at +/- 1000 Hz are different for the two situations and reach amplitudes of about 1% of the amplitude of the water peak (at 0 Hz). Close to the water peak in the center of the spectrum, low frequency side bands at 10-100 Hz can be observed.

It is known that the phases of the eddy current-induced sidebands in the MR spectrum are coherent with the phases of the switched magnetic field gradients. It has thus been proposed (see, e.g., US 2011/0043203 A1) to measure a number of *N*/2 MR signals with positive magnetic field gradients and another number of N/2 MR signals with negative magnetic field gradients (N being an even number). A set of *N* MR signals is thus obtained that are superposed (added) to obtain an averaged MR signal. The sidebands can be eliminated in the spectrum derived from the averaged MR signal to a large extent. This type of gradient cycling does not increase the overall measurement time because signal averaging has to be performed anyway in MR spectroscopy in order to achieve a sufficient SNR (signal to noise-ratio).

However, in sensitive MRS measurements distortions remain visible in the spectrum. In particular, dynamic effects due to a drift of the eddy current behavior caused by system heating are not perfectly corrected.

### SUMMARY OF THE INVENTION

From the foregoing it is readily appreciated that there is a need for an improved technique that overcomes the above problems. It is an object of the invention to enable MRS/MRSI with an improved suppression of magnetic field gradient switching-induced sidebands.

In accordance with the invention, a method of MR imaging or MR spectroscopy of an object placed in the examination volume of a MR device is disclosed. The method comprises the steps of:
- subjecting the object to a first measurement sequence comprising at least one RF excitation pulse and a number of switched magnetic field gradients;
- acquiring first MR signals;
- subjecting the object to a second measurement sequence identical to the first measurement sequence, with the difference that at least some of the switched magnetic field gradients of the second measurement sequence have the opposite polarity of the corresponding switched magnetic field gradients of the first measurement sequence,
- acquiring second MR signals;
- repeating the succession of steps a) through d) a number of times, wherein the acquired first and second MR signals are superposed to obtain averaged MR signals; and
- reconstructing an MR image from the averaged MR signals and/or deriving an MR spectrum from the averaged MR signals.

According to the invention, gradient cycling is applied, wherein two sets of MR signals (first and second MR signals within the meaning of the invention) are acquired using a first and a second measurement sequence respectively. The first and second measurement sequences are identical, with the only difference that at least some of the switched magnetic field gradients of the second measurement sequence have the opposite polarity of the corresponding switched magnetic field gradients of the first measurement sequence. The alternating application of the first and second measurement sequences is repeated a number of times and the thus acquired first and second MR signals are added for averaging. An MR image and/or an MR spectrum is finally derived from the averaged MR signal data.

The resulting MR spectrum is essentially free from sideband artefacts.

It is the gist of the invention that the first and second measurement sequences with positive and negative magnetic field gradients are applied in an alternating fashion shortly after each other so that also effects of slow drift of the sidebands, caused, e.g., by heating or cooling of the used MR system, are efficiently corrected.

The method of artefact reduction according to the invention needs to be implemented individually in the specific measurement sequences, since not all magnetic field gradients can be inverted without effecting the results. Fortunately, especially the large magnetic field gradients, that are the main cause of sidebands, can be inverted without problems.

Crusher-, spoiler- and/or dephasing-gradients can be inverted as well as diffusion gradients. If the corresponding magnetic field gradients are paired to other magnetic field gradients in the specific measurement sequence, all corresponding magnetic field gradients need to be inverted simultaneously.

The measurement-/read out-magnetic field gradients as well as velocity-encoding magnetic field gradients can also be inverted, but do obviously require corresponding adjustments in the reconstruction.

Typically, slice- or slab-selection magnetic field gradients cannot be inverted for gradient cycling according to the invention. This is because, when inverting the selection gradient, the location of the respective chemical substance in the examined object shifts. If the selected location only contains one spectral line (e.g. water) the selection gradient may also be inverted. Note that in that case the offset frequency of the RF pulse needs to be inverted as well in order to keep the selected location unchanged. Slice or slab selection-magnetic field gradients are typically of low amplitude and do not occur very frequently in the measurement sequence. Hence, if the slice- or slab-selection magnetic field gradients of the first and second measurement sequences have equal polarities, this will only have a minor impact on the quality of the resulting MR spectrum.

The method of the invention described thus far can be carried out by means of a MR device including at least one main magnet coil for generating a uniform, steady magnetic field Bo within an examination volume, a number of gradient coils for generating switched magnetic field gradients in different spatial directions within the examination volume, at least one body RF coil for generating RF pulses within the examination volume and/or for receiving MR signals from a body of a patient positioned in the examination volume, a control unit for controlling the temporal succession of RF pulses and switched magnetic field gradients, and a reconstruction unit for reconstructing MR images from the received MR signals. The method of the invention can be implemented by a corresponding programming of the reconstruction unit and/or the control unit of the MR device.

The method of the invention can be advantageously carried out on most MR devices in clinical use at present. To this end it is merely necessary to utilize a computer program by which the MR device is controlled such that it performs the above-explained method steps of the invention. The computer program may be present either on a data carrier or be present in a data network so as to be downloaded for installation in the control unit of the MR device.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows an MR device for carrying out the method of the invention;
Fig 2 shows an MR spectrum of water with eddy current-induced sidebands;
Fig 3 shows an MR spectrum of a phantom comprising water and CH₂ as well as CH₃ illustrating the effect of magnetic field gradient inversion on the phases of the sidebands;
Fig 4 shows an MR spectrum of the phantom with magnetic field gradient cycling according to the invention.

### DETAILED DESCRIPTION OF THE EMBODIMENTS

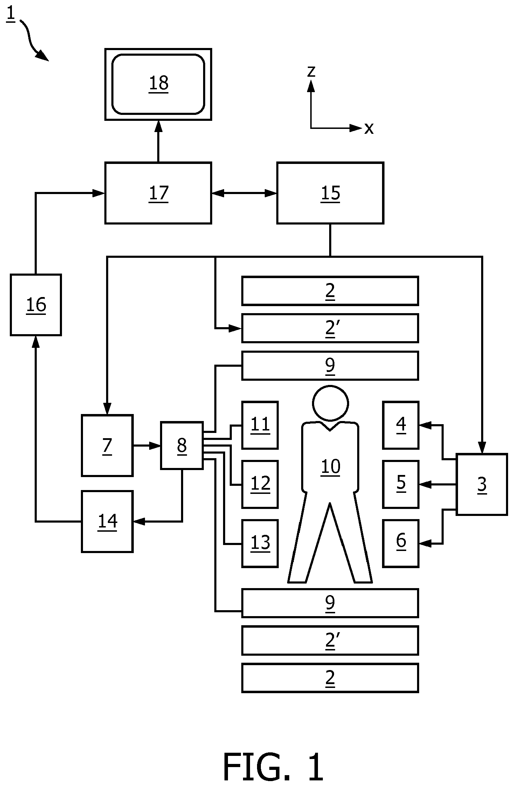

With reference to Fig 1, a MR device 1 is shown as a block diagram. The device comprises superconducting or resistive main magnet coils 2 such that a substantially uniform, temporally constant main magnetic field Bo is created along a z-axis through an examination volume. The device further comprises a set of (1^{st}, 2^{nd}, and - where applicable - 3^{rd} order) shimming coils 2', wherein the current flow through the individual shimming coils of the set 2' is controllable for the purpose of minimizing Bo deviations within the examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging or MR spectroscopy.

More specifically, a gradient amplifier 3 applies current pulses or waveforms to selected ones of whole-body gradient coils 4, 5 and 6 along x, y and z-axes of the examination volume. A digital RF frequency transmitter 7 transmits RF pulses or pulse packets, via a send/receive switch 8, to a body RF coil 9 to transmit RF pulses into the examination volume. A typical MR imaging or MR spectroscopy sequence is composed of a packet of RF pulse segments of short duration which, together with any applied magnetic field gradients, achieve a selected manipulation of nuclear magnetic resonance signals. The RF pulses are used to saturate, excite resonance, invert magnetization, refocus resonance, or manipulate resonance and select a portion of a body 10 positioned in the examination volume. The MR signals are also picked up by the body RF coil 9.

For generation of MR images of limited regions of the body 10 or for scan acceleration by means of parallel imaging, a set of local array RF coils 11, 12, 13 are placed contiguous to the region selected for imaging or spectroscopy. The array coils 11, 12, 13 can be used to receive MR signals induced by body-coil RF transmissions.

The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via send/receive switch 8.

A host computer 15 controls the shimming coils 2' as well as the gradient pulse amplifier 3 and the transmitter 7 to generate any of a plurality of MR imaging sequences, such as echo planar imaging (EPI), echo volume imaging, gradient and spin echo imaging, fast spin echo imaging, and the like. For the selected sequence, the receiver 14 receives a single or a plurality of MR signals in rapid succession following each RF excitation pulse. A data acquisition system 16 performs analog-to-digital conversion of the received signals and converts each MR data sample to a digital format suitable for further processing. In modern MR devices the data acquisition system 16 is a separate computer which is specialized in acquisition of raw image data.

Ultimately, the digital raw image data are reconstructed into an image representation and/or into a spectrum by a reconstruction processor 17 which applies a Fourier transform or other appropriate reconstruction algorithms. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

The host computer 15 is programmed to execute the method of the invention described herein above and in the following.

In a possible embodiment of the invention, a STEAM ("Stimulated Echo Acquisition Mode") measurement sequence is applied. STEAM is a spectroscopic technique using three slice-selective 90° RF pulses applied concurrently with three orthogonal magnetic field gradients (in the x-, y- and z-directions). The three orthogonal slice-selection magnetic field gradients of the measurement sequence are comparatively weak. However, strong crusher gradients are applied immediately after the slice-selection gradients (and the concomitant RF pulses) in order to destroy any undesired transverse magnetization (FIDs). The STEAM signal is then measured as a stimulated echo derived only from protons that have experienced all three RF-pulses. These protons are located in a cuboid-shaped voxel where the three planes overlap.

Fig. 3 shows the ¹H spectra acquired using the STEAM spectroscopy sequence with 11 ms echo time on a phantom containing water, CH₂ and CH₃ groups. The two graphs in Fig. 3 show the same MR spectra on two different frequency scales (top graph from -200 to 200 Hz, bottom graph from -3 kHz to 3 kHz). The spectra suffer from artefacts originating from the switching of the crusher gradients. The gradient switching induces eddy currents leading to a modulation of the acquired MR signals. As can be seen in Fig. 3, the phases of the eddy current-induced sidebands in the MR spectrum are coherent with the phases of the switched magnetic field gradients. The curves 31 and 32 respectively represent the spectra for opposed polarities of the crusher gradients. Fig. 3 shows clearly the inversion of the sidebands, both for the low frequency oscillations and the high frequency oscillations.

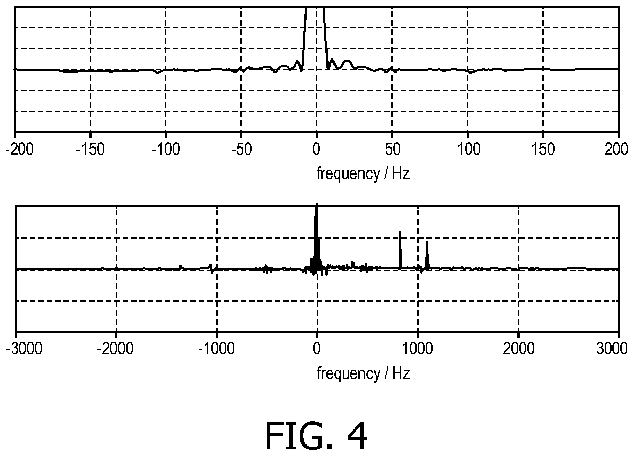

According to the invention, gradient cycling is applied for the crusher gradients of the STEAM sequence. Two sets of MR signals are acquired using the STEAM sequence with positive crusher gradients and negative crusher gradients in an alternating fashion. The alternating application of the two variations of the STEAM sequence is repeated a number of times and the acquired MR signals are added for averaging. The alternating measurement with positive and negative crusher gradients has the effect that a slow drift of the sidebands, caused, e.g., by heating or cooling of the used MR system, is efficiently corrected. Fig. 4 shows the MR spectrum finally derived from the averaged MR signal data. The MR spectrum is essentially free from sideband artefacts and the spectral lines of the CH₂ and CH₃ groups are clearly visible.

## Claims

1. Method of MR imaging or MR spectroscopy of an object (10) positioned in the examination volume of a MR device (1), the method comprising the steps of:
- subjecting the object (10) to a first measurement sequence comprising at least one RF excitation pulse and a number of switched magnetic field gradients;
- acquiring first MR signals;
- subjecting the object (10) to a second measurement sequence identical to the first measurement sequence, with the difference that at least some of the switched magnetic field gradients of the second measurement sequence have the opposite polarity of the corresponding switched magnetic field gradients of the first measurement sequence,
- acquiring second MR signals;
- repeating the succession of steps a) through d) a number of times, wherein the acquired first and second MR signals are superposed to obtain averaged MR signals; and
- reconstructing an MR image from the averaged MR signals and/or deriving an MR spectrum from the averaged MR signals.

2. Method of claim 1, wherein crusher magnetic field gradients, spoiler magnetic field gradients, de-phasing magnetic field gradients and/or diffusion encoding magnetic field gradients of the first and second measurement sequences have opposite polarities.

3. Method of claim 1 or 2, wherein readout magnetic field gradients of the first and second measurement sequences have opposite polarities.

4. Method of any one of claims 1-3, wherein slice- or slab-selection magnetic field gradients of the first and second measurement sequences have equal polarities

5. MR device including at least one main magnet coil (2) for generating a uniform, steady magnetic field Bo within an examination volume, a number of gradient coils (4, 5, 6) for generating switched magnetic field gradients in different spatial directions within the examination volume, at least one RF coil (9) for generating RF pulses within the examination volume and/or for receiving MR signals from an object (10) positioned in the examination volume, a control unit (15) for controlling the temporal succession of RF pulses and switched magnetic field gradients, and a reconstruction unit (17) for reconstructing MR images from the received MR signals, wherein the MR device (1) is arranged to perform the following steps:
- subjecting the object (10) to a first measurement sequence comprising at least one RF excitation pulse and a number of switched magnetic field gradients;
- acquiring first MR signals;
- subjecting the object (10) to a second measurement sequence identical to the first measurement sequence, with the difference that at least some of the switched magnetic field gradients of the second measurement sequence have the opposite polarity of the corresponding switched magnetic field gradients of the first measurement sequence,
- acquiring second MR signals;
- repeating the succession of steps a) through d) a number of times, wherein the acquired first and second MR signals are superposed to obtain averaged MR signals; and
- reconstructing an MR image from the averaged MR signals and/or deriving an MR spectrum from the averaged MR signals.

6. Computer program to be run on a MR device, which computer program comprises instructions for:
- generating a first measurement sequence comprising at least one RF excitation pulse and a number of switched magnetic field gradients;
- acquiring first MR signals;
- generating a second measurement sequence identical to the first measurement sequence, with the difference that at least some of the switched magnetic field gradients of the second measurement sequence have the opposite polarity of the corresponding switched magnetic field gradients of the first measurement sequence,
- acquiring second MR signals;
- repeating the succession of steps a) through d) a number of times, wherein the acquired first and second MR signals are superposed to obtain averaged MR signals; and
- reconstructing an MR image from the averaged MR signals and/or deriving an MR spectrum from the averaged MR signals.
